# EUROPÄISCHE PATENTSCHRIFT

(11) **EP 2 260 683 B1**
(45) Veröffentlichungstag und Bekanntmachung des Hinweises auf die Patenterteilung: **15.05.2013**
(21) Anmeldenummer: 09725562.4
(22) Anmeldetag: 13.03.2009
(51) Int. Cl.: H05K 3/30, H01L 23/367, H01L 23/538, H01L 25/065, H05K 1/18

(54) **VERFAHREN ZUR HERSTELLUNG EINER ELEKTRONISCHEN BAUGRUPPE**
METHOD FOR THE PRODUCTION OF AN ELECTRONIC ASSEMBLY
PROCÉDÉ DE FABRICATION D'UN MODULE ÉLECTRONIQUE

(30) Priorität: 27.03.2008 DE 102008000842
(43) Veröffentlichungstag der Anmeldung: 15.12.2010
(73) Patentinhaber: Robert Bosch GmbH, 70442 Stuttgart (DE)
(72) Erfinder: SCHAAF, Ulrich, 73667 Kaisersbach (DE); KUGLER, Andreas, 73553 Alfdorf (DE)
(86) Internationale Anmeldenummer: PCT/EP2009/052953
(87) Internationale Veröffentlichungsnummer: WO 2009/118249

(56) Entgegenhaltungen:
- EP-A2- 1 684 341
- WO-A1-2006/134220
- WO-A2-2005/008733
- WO-A2-2009/037145
- DE-A1-102006 021 765
- US-A1- 2007 131 349

## Beschreibung

Die Erfindung betrifft ein Verfahren zur Herstellung einer elektronischen Baugruppe gemäß dem Oberbegriff von Anspruch 1, sowie eine elektronische Baugruppe gemäß dem Oberbegriff des Anspruchs 7.

Um elektronische Bauelemente, die in elektronischen Baugruppen auf Leiterplatten eingesetzt werden, verkapseln zu können und um die Flächennutzung auf dem elektronischen Schaltungsträger zu steigern, ist es bekannt, die elektronischen Bauelemente in der Leiterplatte aufzunehmen. Hierdurch ist ein Schutz der elektronischen Bauelemente möglich. Aus US-B 6,512,182 ist es zum Beispiel bekannt, in ein Leiterplattensubstrat Aufnahmen einzufräsen, in welche die elektronischen Bauelemente eingelegt werden. Nach dem Einlegen der elektronischen Bauelemente werden die Aufnahmenaufgefüllt, anschließend geglättet und überlaminiert. Durch das Einbetten der elektronischen Bauelemente lässt sich eine glatte Oberfläche der elektronischen Baugruppe erzielen.

Nachteil dieser Baugruppe ist es, dass zunächst Aufnahmen in das Leiterplattensubstrat eingefräst werden, in welches die elektronischen Bauelemente eingesetzt werden. Eine exakte Positionierung der elektronischen Bauelemente ist auf diese Weise nur schwer möglich.

Aus DE-A 10 2005 003 125 ist ein Verfahren zur Herstellung einer elektrischen Schaltung bekannt, wobei die Schaltung elektrische Bauelemente aufweist, die mechanisch durch eine Vergussmasse miteinander verbunden sind. Auf mindestens einer Seite der Vergussmasse ist mindestens eine Schicht Leiterbahnen vorgesehen, die die Bauelemente elektrisch miteinander verbindet. Zur Herstellung der Schaltung werden die Bauelemente auf einer Trägerfolie aufgebracht und anschließend mit einer Vergussmasse umgossen. Daran anschließend wird die Trägerfolie entfernt und auf der Seite, auf der die Bauelemente mit der Trägerfolie verbunden waren, werden ein oder mehrere Schichten von Leiterbahnen aufgebracht, die die Bauelemente elektrisch miteinander verbinden.

Nachteil dieses Verfahrens ist es, dass die Trägerfolie rückstandsfrei entfernt werden muss, um eine funktionsfähige Anbindung der elektrischen Schaltung zu erzielen.

Ein weiterer Nachteil der aus dem Stand der Technik bekannten Verfahren ist, dass aufgrund der Leiterplattenstruktur die Bestückfläche auf der Leiterplatte begrenzt ist. Zudem sind die Anschlüsse teilweise relativ lang, was bei Anwendungen im Bereich hoher Taktfrequenzen nachteilig ist.

Als weiterer Stand der Technik ist in DE 10 2006 021 765 A1, die u.a. die Merkmale des Oberbegriffs von Anspruch 1 aufweist, generell ein Verfahren zum Herstellen einer Leiterplatte mit eingebetteten Komponenten beschrieben. Das Verfahren umfasst die Schritte des Montierens von Elektronikkomponenten auf einer Seite einer ersten Metallfolie, des Anordnens eines Laminierungsglieds zwischen der ersten Metallfolie und einer zweiten Metallfolie, wobei die Oberfläche mit montierten Elektronikkomponenten der ersten Metallfolie dem Laminierungsglied zugewandt ist, des Andrückens der ersten Metallfolie und der zweiten Metallfolie an das Laminierungsglied, um eine Kernschicht auszubilden, bei der Elektronikkomponenten in das Laminierungsglied eingebettet sind, und des Ausbildens von Schaltungsstrukturen auf der ersten Metallfolie und der zweiten Metallfolie.

Ferner ist aus der US 2007/0131349 A1 ein elektrisches Modul und ein Verfahren zur Herstellung des elektronischen Moduls bekannt, wobei eine leitende Schicht und eine elektronische Komponente vorgesehen sind, die eine Kontaktfläche mit Kontaktbereichen aufweist. Die elektronische Komponente wird mit der Kontaktflächenseite an eine Oberfläche der leitenden Schicht unter Verwendung eines anisotrop leitenden Kleber geklebt, so dass ein elektrischer Kontakt zwischen den Kontaktflächen des Bauteils und der leitenden Schicht gebildet wird. Ferner ist eine Isolierschicht an der Oberfläche der leitenden Schicht vorgesehen, die die Komponente umgibt, wobei leitfähige Muster durch die leitende Schicht ausgebildet sind.

Die Aufgabe der Erfindung ist es, die Nachteile des Stands der Technik zu beheben und dadurch ein vereinfachtes Verfahren zur Herstellung einer elektronischen Baugruppe sowie eine elektronische Baugruppe selbst bereitzustellen. Diese Aufgabe wird durch ein Verfahren mit den Merkmalen des Anspruchs 1 sowie eine elektronische Baugruppe mit den Merkmalen des Anspruchs 7 gelöst.

Das erfindungsgemäße Verfahren zur Herstellung einer elektronischen Baugruppe weist die Merkmale des neuen Anspruchs 1 auf.

Im Sinne der vorliegenden Erfindung sind die Kontaktierungspunkte kleine Erhebungen aus einem leitfähigen Material, die an den Kontaktierungsstellen des elektronischen Bauteils angebracht sind. Die Höhe der Erhebungen entspricht dabei dem Abstand, den das elektronische Bauteil von der elektrisch leitfähigen Folie einnehmen soll. Geeignete Kontaktierungspunkte sind zum Beispiel Lötbumps oder Studbumps. Die Kontaktierungspunkte dienen gleichzeitig zur Ankontaktierung des elektronischen Bauelements an die elektrisch leitfähige Folie. Auf diese Weise werden kurze Anschlüsse realisiert, die insbesondere bei Anwendungen im Bereich hoher Taktfrequenzen vorteilhaft sind. Ein Vorteil ist es, dass hierdurch das elektronische Bauteil schon während der Montage ankontaktiert wird, wodurch sich die Anzahl der Prozessschritte reduzieren lässt. Ein Vorteil der Ankontaktierung der elektronischen Bauteile mit den Kontaktierungspunkten ist, dass kein Platz benötigt wird, oben liegende Anschlüsse des elektronischen Bauelements mit der elektrisch leitfähigen Folie zu verbinden. Auf diese Weise kann eine dichtere Bestückung erfolgen, woraus eine gesteigerte Flächennutzung resultiert.

Ein weiterer Vorteil ist es, dass risikoreiche Mischtechniken, beispielsweise Löten, Kleben und Drahtbonden, in der Fertigung vermieden werden.

Ein weiterer Vorteil des erfindungsgemäßen Verfahrens ist es, dass sich die elektronischen Bauelemente durch das Befestigen auf der leitfähigen Folie exakt positionieren lassen. Beim anschließenden Auflaminieren der leitfähigen Folie mit dem mindestens einen daran befestigten elektronischen Bauelement auf einen Leiterplattenträger, wobei das mindestens eine elektronische Bauelement in Richtung des Leiterplattenträgers weist, wird das mindestens eine elektronische Bauelement vom Leitungsträger umschlossen. Hierdurch wird das Bauelement vollständig gekapselt. Durch die komplette Kapselung empfindlicher Bauelemente wird eine hohe Zuverlässigkeit der elektronischen Baugruppe erzielt.

Weiterhin wird eine planare Ausgangsstruktur erzielt, wodurch reproduzierbare Hochfrequenz-Übergänge erzeugt werden.

Durch das Strukturieren der leitfähigen Folie nach dem Auflaminieren auf den Leiterplattenträger werden auf einfache Weise die notwendigen Leiterbahnen hergestellt. Eine schnelle und kostengünstige Fertigung der elektronischen Baugruppe ist hierdurch möglich.

Die leitfähige Folie kann eine isolierende Schicht aufweisen. Das mindestens eine Bauelement wird auf der isolierenden Schicht befestigt, wobei die Kontaktierungspunkte die isolierende Schicht durchbrechen und das Bauelement mit der leitfähigen Folie kontaktieren. Die isolierende Schicht wirkt als Dielektrikum und dient dazu, dass nicht die gesamte aktive Seite des elektronischen Bauelements auf der leitfähigen Folie aufliegt.

Zum Befestigen des mindestens einen elektronischen Bauelements wird Klebstoff auf die leitfähige Folie aufgetragen. Der Klebstoff wirkt als Dielektrikum zwischen der leitfähigen Folie und dem mindestens einen elektronischen Bauelement. Auch hier kontaktieren die Kontaktierungspunkte das Bauelement mit der leitfähigen Folie. Vorteil dabei ist, dass eine Beschichtung der leitfähigen Folie nicht notwendig ist. Dies hat gegenüber der beschichteten Folie Kostenvorteile, da das Aufbringen von Klebstoff auf eine Folie kostengünstiger ist als das Beschichten einer Folie.

Zusätzlich zu den Bauelementen mit Kontaktierungspunkten ist es weiterhin möglich, dass auch mindestens ein weiteres elektronisches Bauelement ohne Kontaktierungspunkte auf einer isolierenden Schicht oder einer Klebstoffschicht auf der leitfähigen Folie befestigt wird.

Vorzugsweise wird das mindestens eine elektronische Bauelement und gegebenenfalls das mindestens eine weitere elektronische Bauelement nach dem Befestigen auf der leitfähigen Folie von einer Polymermasse umschlossen. Das Umschließen des mindestens einen elektronischen Bauelements mit der Polymermasse führt zu einem zusätzlichen Schutz des Bauelements. Hierdurch wird auch bei empfindlichen Bauelementen die Gefahr einer Beschädigung deutlich gemindert.

Die Polymermasse, mit der das mindestens eine elektronische Bauelement und gegebenenfalls das mindestens eine weitere elektronische Bauelement umschlossen wird, ist zum Beispiel eine Niederdruckpressmasse, beispielsweise eine Epoxy-Niederdruckpressmasse. Die Niederdruckpressmasse wird zum Beispiel durch ein Spritzpressverfahren aufgebracht. In der Polymermasse können zusätzlich Platzhalter, zum Beispiel für dickere Dielektrika, freigehalten werden. Diese können jedoch auch als Einlegeteile beim Umspritzen des mindestens einen elektronischen Bauelements mit umspritzt werden.

Das Befestigen des mindestens einen elektronischen Bauelements und gegebenenfalls des mindestens einen weiteren elektronischen Bauelements erfolgt vorzugsweise durch Aufkleben. Hierzu ist es bevorzugt, dass die leitfähige Trägerfolie eine Klebeschicht aufweist. Die Klebeschicht bildet dabei vorzugsweise gleichzeitig die isolierende Schicht. Die leitfähige Folie ist dabei zum Beispiel eine selbstklebende leitfähige Folie. Das Aufkleben kann durch Heiß- und Druckprozesse erfolgen. Dies ist zum Beispiel auch ein Heißklebeprozess. Das Aufkleben des mindestens einen Bauelements und gegebenenfalls des mindestens einen weiteren Bauelements kann durch Auftragen von Klebstoff auf die elektrisch leitfähige Folie erfolgen. Das Auftragen des Klebstoffes kann dabei durch jedes beliebige, dem Fachmann bekannte Verfahren erfolgen. So ist es zum Beispiel möglich, den Klebstoff in Form von Klebstoffpunkten auf die elektrisch leitfähige Folie aufzutragen. Weiterhin ist es auch möglich, die elektrisch leitfähige Folie zum Beispiel mit einer Klebstoffschicht zu bestreichen. Vorzugsweise wird der Klebstoff jedoch in Form von Klebstoffpunkten an den Positionen, an denen elektronische Bauelemente angebracht werden, aufgetragen.

Die leitfähige Folie, die eingesetzt wird, ist zum Beispiel eine Kupferfolie, wie sie auch als RCC-Material aus der Leiterplattentechnik bekannt ist. Weitere geeignete leitfähige Folien sind beispielsweise LCP-Folien oder PI-Folien. Als Metall eignet sich neben Kupfer zum Beispiel auch Aluminium.

Vor dem Aufbringen des mindestens einen elektronischen Bauelements auf die leitfähige Folie können Justagemarken in die leitfähige Folie eingebracht werden. Die Justagemarken sind zum Beispiel Löcher oder Sacklöcher mit einem beliebigen Querschnitt. Diese können zum Beispiel durch Ätzen, Stanzen oder Bohren in die leitfähige Folie eingebracht werden. Die Justagemarken werden dabei auf der dem mindestens einen elektronischen Bauelement gegenüberliegenden Seite der leitfähigen Folie angebracht. Durch die Justagemarken lässt sich auch nach dem Umschließen des mindestens einen elektronischen Bauelements mit der Polymermasse bzw. nach dem Auflaminieren der leitfähigen Folie auf den Leiterplattenträger die genaue Position des mindestens einen elektronischen Bauelements und gegebenenfalls des mindestens einen weiteren elektronischen Bauelements bestimmen. Dies ist zum einen für die Ausbildung der Leiterbahnstruktur erforderlich, zum anderen ist es für die Kontaktierung des mindestens einen weiteren Bauelements, sofern ein solches ohne Kontaktierungspunkte aufgebracht wird, notwendig. Alternativ eignen sich als Justagemarken zum Beispiel auch Bauelemente, mit denen die leitfähige Folie bestückt ist. An den Stellen, an denen die Bauelemente angeordnet sind, wird die leitfähige Folie vorzugsweise freigebohrt oder geröntgt, um die Bauelemente zu erkennen. Daneben können die Justagemarken selbstverständlich auch jede andere, dem Fachmann bekannte Form aufweisen.

Wenn weitere elektronische Bauelemente, die keine Kontaktierungspunkte aufweisen, aufgesetzt werden, werden an den Positionen, an denen das mindestens eine weitere elektronische Bauelement mit der leitfähigen Trägerfolie elektrisch kontaktiert werden soll, vorzugsweise Löcher eingebracht. Zur Kontaktierung der leitfähigen Folie mit dem mindestens einen weiteren elektronischen Bauelement werden die Löcher zum Beispiel metallisiert. Das Einbringen der Löcher erfolgt zum Bespiel durch Laserbohren. Die Positionen, an denen die Löcher eingebracht werden, werden anhand der Justagemarken bestimmt.

Das Metallisieren der Löcher, um einen Kontakt des mindestens einen weiteren elektronischen Bauelements mit der leitfähigen Trägerfolie zu erzielen, erfolgt nach dem Fachmann bekannten Verfahren. Das Metallisieren kann zum Beispiel durch stromlose Metallabscheidung erfolgen. Die stromlose Metallabscheidung ist ein übliches Verfahren, welches in der Leiterplattenherstellung eingesetzt wird. Das Metallisieren der Löcher erfolgt vorzugsweise mit Kupfer.

Weitere Leiterbahnen lassen sich zum Beispiel dadurch aufbringen, indem auf die in Schritt (c) strukturierte leitfähige Folie weitere Lagen, die Leiterbahnstrukturen enthalten, aufgebracht werden. Hierzu wird vorzugsweise zunächst ein Dielektrikum aufgebracht, durch welches die in Schritt (c) ausgebildeten Leiterbahnen abgedeckt werden. Gleichzeitig erfolgt hierdurch eine Isolierung der Leiterbahnen, damit kein unerwünschter elektrischer Kontakt mit den Leiterbahnen der nachfolgend aufgebrachten Schicht erfolgt. Daran anschließend werden auf das Dielektrikum nach dem Fachmann bekannten Verfahren weitere Leiterbahnen aufgebracht. Die weiteren Lagen, die Leiterbahnen enthalten, können alternativ auch durch Aufbringen weiterer leitfähiger Folien auf die erste Lage und anschließendem Strukturieren der Folie zur Ausbildung von Leiterbahnen hergestellt werden. Die Folien umfassen vorzugsweise eine klebende isolierende Schicht, mit der diese auf die Leiterbahnen aufgebracht werden.

Die Kontaktierung zwischen zwei Lagen mit Leiterbahnen erfolgt durch Einbringen von Löchern und anschließendes Metallisieren der Löcher. Alternativ ist es auch möglich, an den Positionen, an denen die Leiterbahnen der zweiten Schicht die Leiterbahnen der ersten Schicht kontaktieren sollen, kein Dielektrikum aufzubringen.

Um beim Betrieb der elektronischen Baugruppe entstehende Wärme abzuführen, ist es bevorzugt, dass das mindestens eine elektronische Bauelement nach dem Auflaminieren der leitfähigen Folie auf den Leiterplattenträger in Schritt (b) auf der von der leitfähigen Folie wegweisenden Seite mit einem Kühlkörper kontaktiert wird, so dass der Kühlkörper nach dem Auflaminieren auf den Leiterplattenträger ebenfalls in der Leiterplatte integriert ist. Der Kühlkörper kann dabei jeder beliebige, dem Fachmann bekannte Kühlkörper sein. So ist es zum Beispiel möglich, dass der Kühlkörper ein Metallkern ist. Im Betrieb gibt dann das elektronische Bauelement an den Metallkern Wärme ab, über den diese nach außen abgegeben werden kann.

Durch das erfindungsgemäße Verfahren lässt sich eine kostengünstige Verdrahtung und Verkapselung erzielen, durch den Einsatz von Prozessen auf vielen Modulen gleichzeitig. Ein weiterer Vorteil ist, dass die elektronische Baugruppe als Standard-Bauteil weiterverarbeitet werden kann.

Weiterhin betrifft die Erfindung eine elektronische Baugruppe mit den Merkmalen von Anspruch 7, umfassend mindestens ein elektronisches Bauelement, das mit einer Leiterbahnstruktur auf einer Leiterplatte verbunden ist. Das mindestens eine elektronische Bauelement ist in einem Leiterplattenträger eingebettet und die Leiterbahnstruktur ist an der Oberfläche der Leiterplatte angeordnet. Die Kontaktierung des Bauelements mit der Leiterbahnstruktur erfolgt durch am Bauelement angebrachte Kontaktierungspunkte. Neben der vorstehend schon erwähnten kostengünstigen Verkapselung und damit hohen Zuverlässigkeit wird die teure Substrat- und Packagetechnik, wie sie derzeit im Stand der Technik eingesetzt wird, ersetzt bzw. auf ein kleines Bauelement reduziert. Zudem ist es bei der erfindungsgemäßen elektronischen Baugruppe möglich, eine komplette Hochfrequenz-Schaltung auf einem Modul inklusive Antennen zu konzentrieren. Die erfindungsgemäß hergestellte elektronische Baugruppe kann als Standard-Bauteil weiterverarbeitet werden.

Die Kontaktierungspunkte sind vorzugsweise Lötbumps oder Studbumps. Weiterhin geeignet sind auch galvanisch hergestellte Bumps aus unterschiedlichen Materialien, z.B. Kupfer oder Gold. Durch ein automatisiertes Aufbringen der Lötbumps oder Studbumps ist es möglich, dass diese jeweils eine gleichmäßige Höhe aufweisen. Hierdurch lässt sich ein gleichmäßiger Abstand des elektronischen Bauelements von der leitfähigen Folie erzielen.

In einer bevorzugten Ausführungsform ist die Leiterbahnstruktur in mehreren Lagen ausgebildet. Hierdurch ist eine gesteigerte Flächennutzung auf einem elektronischen Schaltungsträger möglich. Durch die zusätzlichen Lagen lässt sich die elektronische Baugruppe auf engstem Raum mit Bauteilen bestücken und kontaktieren.

Um gut Wärme abführen zu können, die beim Betrieb der elektronischen Baugruppe entsteht, ist es bevorzugt, dass in der Leiterplatte ein Kühlkörper enthalten ist. Als Kühlkörper eignet sich zum Beispiel ein Metallkern, an den das mindestens eine elektronische Bauelement metallisch angebunden ist.

Neben dem mindestens einen elektronischen Bauelement ist es auch möglich, dass die elektronische Baugruppe ein oder mehrere mechanische Bauelemente enthält.

Elektronische Bauelemente, die bei dem erfindungsgemäßen Verfahren bzw. bei der erfindungsgemäß ausgebildeten elektronischen Baugruppe eingesetzt werden, sind alle dem Fachmann bekannten elektronischen Bauelemente, wie sie in der Leiterplattentechnologie und Mikroelektronik verwendet werden. Auch als mechanische Bauelemente kommen alle Bauelemente in Betracht, wie sie in der Leiterplattentechnologie eingesetzt werden.

Ausführungsbeispiele und Vergleichsbeispiele der Erfindung sind in den Zeichnungen dargestellt und in der nachfolgenden Beschreibung näher erläutert.

Es zeigen
- Figuren 1-5: mehrere Schritte der Herstellung einer erfindungsgemäßen Vorrichtung in einer Ausführungsform,
- Figuren 6-10: mehrere Schritte der Herstellung einer erfindungsgemäßen Vorrichtung in einem Vergleichsbeispiel.

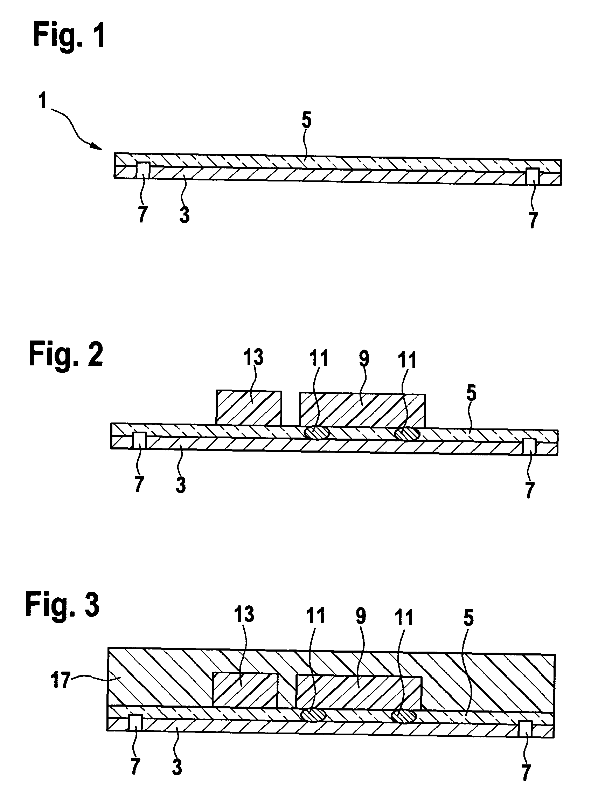

In Figur 1 ist eine leitfähige Folie 1 dargestellt, die eine leitfähige Schicht 3 und eine isolicrende Schicht 5 umfasst. Die isolierende Schicht 5 ist vorzugsweise eine Klebschicht oder ein Thermoplast, auf die elektronische Bauelemente aufgebracht werden können. Auf der Seite der leitfähigen Folie 1, auf der sich die leitfähige Schicht 3 befindet, werden Justagemarken 7 eingebracht. Die Justagemarken 7 können zum Beispiel durch Ätzen, Stanzen, Bohren, beispielsweise Laserbohren, in die leitfähige Folie 1 eingebracht werden. Weiterhin ist es möglich, dass die Justagemarken 7 auch mit der leitfähigen Folie 1 verbundene Bauelemente sind, die freigebohrt oder durch Röntgenmikroskopie detektiert werden. Auch jede andere, dem Fachmann bekannte Form für Justagemarken ist möglich.

Die leitfähige Schicht 3 ist vorzugsweise eine Metallschicht. Besonders bevorzugt als Metall ist Kupfer.

In einem zweiten Schritt werden auf die isolierende Schicht 5 elektronische Bauelemente 9 aufgebracht. Dies ist in Figur 2 dargestellt. Das elektronische Bauelement wird mit seiner aktiven Seite zur leitfähigen Folie 1 hin befestigt. Am elektronischen Bauelement 9 sind an den Positionen, mit denen das elektronische Bauelement 9 mit der leitfähigen Folie 1 kontaktiert wird, Kontaktpunkte 11 angebracht. Die Kontaktpunkte 11 sind vorzugsweise Erhebungen oder Höcker aus einem elektrisch leitfähigen Material. Bevorzugt sind die Kontaktpunkte 11 Lötbumps oder Studbumps. Neben dem elektrischen Bauelement 9 mit Kontaktpunkten 11 ist es weiterhin möglich, weitere elektronische Bauelemente 13, die keine Kontaktpunkte 11 aufweisen, auf der isolierenden Schicht 5 der leitfähigen Folie 1 aufzubringen. Neben elektronischen Bauelementen 9, 13 ist es auch möglich, dass auf die isolierende Schicht 5 der leitfähigen Folie 1 mechanische Bauelemente aufgebracht werden. Die elektronischen Bauelemente 9, 13 bzw. mechanischen Bauelemente, die auf die isolierende Schicht 5 der leitfähigen Folie 1 aufgebracht werden, sind übliche Bauelemente, wie sie im Leiterplattenbau eingesetzt werden. Hierbei handelt es sich zum Beispiel um Chips, Prozessoren, Hochfrequenzbauteile, SMD-Komponenten, Antennenmodule, Kühlkörper, MEMS oder MOEMS.

Das Aufbringen der elektronischen Bauelemente 9, der weiteren elektronischen Bauelemente 13 bzw. der mechanischen Bauelemente erfolgt vorzugsweise durch Aufkleben auf die isolierende Schicht 5. Hierbei werden die elektronischen Bauelemente 9, 13 so auf die isolierende Schicht 5 der leitfähigen Folie 1 platziert, wie die elektronischen Bauelemente 9, 13 später in der elektrischen Schaltung angeordnet sein sollen. Es können auf einzelne oder alle elektronischen Bauelemente 9, 13 zum Beispiel Kühlkörper aufgebracht werden, um eine erhöhte Wärmeabfuhr während des Betriebes der elektronischen Bauelemente 9, 13 zu gewährleisten. Die optional vorsehbaren Kühlkörper werden hierbei auf der Seite der elektronischen Bauelemente 9, 13 aufgesetzt, die der leitfähigen Folie 1 abgewandt ist.

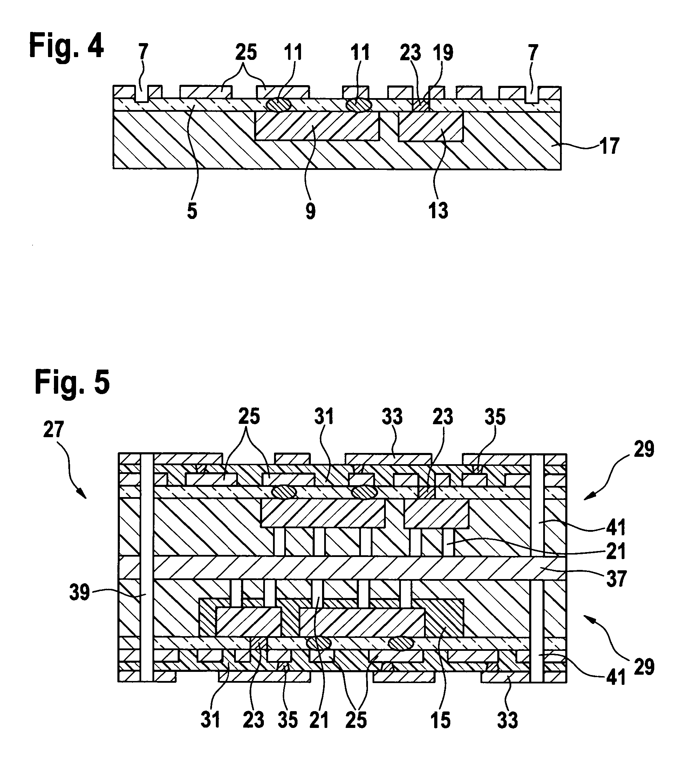

Um eine Kapselung von empfindlichen elektronischen Bauelementen 9, 13 zu erzielen, ist es möglich, diese mit einer Polymermasse 15 zu umschließen. Dies ist zum Beispiel in Figur 5 dargestellt. Die Polymermasse 15 ist zum Beispiel eine Epoxy-Niederdruckpressmasse. In die Polymermasse 15 können, wenn erforderlich, zum Beispiel Platzhalter für dickere Dielektrika, die zum Beispiel für Antennen oder Kühlkörper verwendet werden, umspritzt werden. Das Umhüllen mit der Polymermasse 15 erfolgt zum Beispiel mittels eines Spritzpressverfahrens. Die Platzhalter können zum Beispiel als Vertiefungen oder Wannen ausgeformt sein. Neben dem Spritzpressverfahren ist jedoch auch jedes andere, dem Fachmann bekannte Verfahren, einsetzbar, mit dem sich die elektronischen Bauelemente 9, 13 mit der Polymermasse 15 ummanteln lassen. Zusätzlich hat die Ummantelung mit der Polymermasse 15 den Vorteil, dass ein Höhenausgleich bei Bauelementen 9, 13 mit unterschiedlicher Dicke möglich ist. Dies ist vorteilhaft für den nachfolgenden Laminierprozess. Bauteile können zudem auf abziehbarer Folie vorverkapselt werden und nach dem Abziehen der Folie auf die leitfähige Folie 1 montiert werden.

Nach dem Aufbringen der elektronischen Bauelemente 9 auf die leitfähige Folie 1 oder, wenn die elektronischen Bauelemente 9, 13 von der Polymermasse umschlossen werden sollen, nach dem Umschließen der elektronischen Bauelemente 9, 13 mit der Polymermasse 15, wird die leitfähige Folie 1 auf Leiterplattenzuschnitt zugeschnitten.

Nach dem Zuschneiden wird die leitfähige Folie 1 mit den darauf angebrachten elektronischen Bauelementen 9, 13 und gegebenenfalls weiteren mechanischen Bauelementen, die hier nicht dargestellt sind, auf einen Leiterplattenträger 17 auflaminiert. Dies ist in Figur 3 dargestellt. Bei der hier dargestellten Ausführungsvariante ist die leitfähige Folie 1 mit den elektronischen Bauelementen 9, 13 auf den Leiterplattenträger 17 auflaminiert worden, ohne dass die elektronischen Bauelemente 9, 13 von der Polymermasse 15 umschlossen worden sind. Erfindungsgemäß wird aber auch die in Figur 5 dargestellte Ausführungsform, bei der die elektronischen Bauelemente 9, 13 von der Polymermasse 15 umschlossen sind, auf den Leiterplattenträger 17 auflaminiert. Das Auflaminieren erfolgt dabei nach dem Fachmann bekannten Verfahren. Der Leiterplattenträger 17 wird erfindungsgemäß derart auf die leitfähige Folie 1 auflaminiert, dass die elektronischen Bauelemente 9, 13 oder die von der Polymermasse 15 umschlossenen elektronischen Bauelemente 9, 13 vom Leiterplattenträger 17 umschlossen werden. Hierzu wird der Leiterplattenträger 17 auf der Seite auf die leitfähige Folie 1 auflaminiert, auf der auch die elektronischen Bauelemente 9 angebracht sind.

Im Allgemeinen wird hierzu bei Bauelementen 9, 13, deren Bauteildicke größer als 0,1 mm ist, zunächst ein glasfaserverstärktes und an den Stellen der Bauelemente 9, 13 vorgebohrtes, ausgehärtetes Leiterplattenmaterial auf die Folie aufgelegt. Hierauf wird ein Prepreg und gegebenenfalls ein weiteres ausgehärtetes Leiterplattenmaterial aufgelegt. Dieser Stapel wird dann in einem Laminierprozess verpresst. Das ausgehärtete Leiterplattenmaterial ist üblicherweise ein glasfaserverstärktes Epoxidharz. Es ist jedoch auch jedes andere geeignete, dem Fachmann bekannte Material einsetzbar. Als Prepreg wird im Allgemeinen ebenfalls ein Epoxidharz eingesetzt. Dieses ist jedoch noch nicht vollständig ausgehärtet. Durch Aufbringen von Druck und einer erhöhten Temperatur härtet das Prepreg vollständig aus, wodurch sich dieses mit dem ausgehärteten Leiterplattenmaterial verbindet. Der Verbund aus Prepreg und ausgehärtetem Leiterplattenmaterial bildet den Leiterplattenträger 17.

Nach dem Auflaminieren der leitfähigen Folie 1 mit den elektronischen Bauelementen 9, 13 bzw. mit den gegebenenfalls von der Polymermasse 15 umschlossenen elektronischen Bauelementen 9, 13 auf den Leiterplattenträger 17 werden an den Anschlussstellen der weiteren elektronischen Bauelemente 13, die keine Kontaktpunkte 11 aufweisen, Löcher 19 in die leitfähige Folie 1, umfassend die leitfähige Schicht 3 und die isolierende Schicht 5, eingebracht. Die richtige Positionierung der Löcher 19 kann durch die anfangs eingebrachten Justagemarken 7 ermittelt werden. Hierdurch ist es möglich, genau an den Positionen, an denen sich die elektrischen Anschlüsse der weiteren elektronischen Bauelemente 13 befinden, die Löcher 19 zu erzeugen. Die elektronischen Bauelemente 9, die Kontaktpunkte 11 aufweisen, werden mit ihren Kontaktpunkten 11 an der leitfähigen Schicht 3 der leitfähigen Folie 1 kontaktiert.

Üblicherweise werden gleichzeitig mit dem Einbringen der Löcher 19 zur Kontaktierung der weiteren elektronischen Bauelemente 13 mit der leitfähigen Schicht 3 oder direkt im Anschluss daran Kühlkanäle 21, wie sie in der Figur 5 dargestellt sind, in den Leiterplattenträger 17 gebohrt. Hierzu wird zum Beispiel ein Laserbohrverfahren eingesetzt. Wenn auch die Löcher 19 durch ein Laserbohrverfahren erzeugt werden, wird für die Kühlkanäle 21 vorzugsweise ein zweiter Laser eingesetzt. Es können aber auch alle Löcher 19 und Kühlkanäle 21 mit dem gleichen Laser gebohrt werden.

Durch Metallisierung werden die weiteren elektronischen Bauelemente 13 mit der leitfähigen Schicht 3 elektrisch kontaktiert. Dies ist in Figur 4 dargestellt. Zur Metallisierung wird durch dem Fachmann bekannte Verfahren, zum Beispiel durch stromlose Metallabscheidung, Metall 23 in den Löchern 19 abgeschieden. Dieses Metall verbindet die Anschlüsse der weiteren elektronischen Bauelemente 13 mit der leitfähigen Schicht 3. Ein elektronischer Kontakt wurde hergestellt. Üblicherweise ist das Metall 23, das zur Metallisierung eingesetzt wird, Kupfer. Für die Metallisierung wird im Allgemeinen zunächst stromlos eine Startmetallisierung aus Palladium abgeschieden. Daran anschließend erfolgt eine galvanische Kupferabscheidung. Das Metall 23 kann die Form einer Hülse einnehmen oder die Löcher 19 vollständig füllen.

Nach dem Einbringen der Löcher 19 für die Kontaktierung der weiteren elektronischen Bauelemente 13 in die leitfähige Folie 1 und der Metallisierung der Löcher 19 wird die leitfähige Schicht 3, wie in Figur 4 dargestellt, strukturiert. Das Strukturieren erfolgt dabei durch ein beliebiges, dem Fachmann bekanntes Verfahren. Geeignete Verfahren sind zum Beispiel Ätzverfahren, Photoresistverfahren, Laserbohrverfahren oder Laserablationsverfahren.

Durch die Strukturierung der leitfähigen Schicht werden die für die Leiterplatte notwendigen Leiterbahnstrukturen 25 erzeugt.

Durch das Einbetten der elektronischen Bauelemente 9, 13 in den Leiterplattenträger 17 wird eine ebene Oberfläche erzielt. Hierdurch ist eine einfache Verarbeitung der Oberfläche möglich. Selbstverständlich ist es jedoch auch möglich, zuerst die Leiterbahnstruktur 25 aus der leitfähigen Folie 1 auszuarbeiten und daran anschließend die Löcher in die lcitfähige Folie 1 einzubringen und zu metallisieren.

In Figur 5 ist eine elektronische Baugruppe 27 dargestellt. Die elektronische Baugruppe 27 umfasst zwei Leiterplatten 29. Auf die Leiterbahnstruktur 25 ist ein Dielektrikum 31 aufgebracht, um eine weitere Leiterbahnstruktur 33 aufzubringen. Als Dielektrikum 31 eignen sich zum Beispiel Epoxidharze oder FR4-Materialien, die aus der Leiterplattentechnik bekannt sind. Das Aufbringen des Dielektrikums 31 erfolgt mit den üblichen, dem Fachmann bekannten Verfahren. So ist es zum Beispiel möglich, das Dielektrikum 31 durch Rakeln, Streichen, Drucken, Auflaminieren, Vorhangguss, Filmcoating, Spray-Coating oder ähnliche Verfahren aufzubringen.

Auf das Dielektrikum 31 wird eine weitere Leiterbahnstruktur 33 aufgebracht. Hierzu ist es möglich, zunächst vollflächig eine leitfähige Schicht aufzutragen, die anschließend strukturiert wird.

Bevorzugt ist es auch möglich, auf die erste Leiterbahnstruktur 25 eine weitere leitfähige Folie aufzutragen und aus der leitfähigen Schicht der zweiten leitfähigen Folie die Leiterbahnstruktur 33 zu strukturieren. Dies erfolgt dann vorzugsweise nach dem gleichen Verfahren wie die Strukturierung der leitfähigen Schicht 3 zur Leiterbahnstruktur 25. Nach dem Herstellen der Leiterbahnstruktur 33 können Löcher 35 in das Dielektrikum 31 eingebracht werden, durch die mittels Metallisierung eine Kontaktierung der Leiterbahnstruktur 25 mit der weiteren Leiterbahnstruktur 33 erfolgt.

Besonders bevorzugt werden zur Herstellung mehrerer leitfähiger, zu Leiterbahnen strukturierter Schichten zunächst das Dielektrikum 31 und anschließend eine leitfähige Folie auflaminiert. Nach dem Auflaminieren des Dielektrikums 31 und der leitfähigen Folie werden zunächst Löcher eingebracht, die anschließend metallisiert werden, um die leitfähige Folie mit darunterliegenden Schichten elektrisch zu verbinden. Daran anschließend wird aus der leitfähigen Folie die weitere Leiterbahnstruktur 33 herausgearbeitet.

Um Wärme von den elektronischen Bauelementen 9, 13 abzuführen, ist es möglich, an der den Leiterbahnstrukturen 25, 33 abgewandten Seite der elektronischen Bauelemente 9, 13 Kühlkanäle 21 in den Leiterplattenträger 17 einzubringen. Die Kühlkanäle 21 können mit einem Kühlkörper 37 verbunden werden. In der in Figur 5 dargestellten Ausführungsform ist der Kühlkörper 37 ein Metallkern. Über den Kühlkörper 37 und die Kühlkanäle 21 wird Wärme von den elektronischen Bauelementen 9, 13 abgeführt. Das Anbinden der Kühlkanäle 21 an den Kühlkörper 37 erfolgt im Allgemeinen über eine Rückseitenmetallisierung oder alternative Anbindungen, bei der die Innenwände der Kühlkanäle 21 mit einer Metallschicht versehen werden. Es ist aber auch möglich, die Kühlkanäle 21 vollständig mit einem Metall zu füllen.

Weiterhin ist es auch möglich, zwischen dem als Metallkern ausgebildeten Kühlkörper 37 und dem elektronischen Bauelement 9, 13 Kühlelemente vorzusehen. Auch ist es möglich, den Metallkern so zu gestalten, dass dieser die elektronischen Bauelemente 9, 13 direkt kontaktiert.

Die Verbindung der Leiterplatten 29 erfolgt vorzugsweise ebenfalls mittels eines Laminierprozesses, wie dies bei Leiterplattenherstellungsprozessen üblich ist.

Mit einer Bohrung 39, die durch beide Leiterplatten 29 hindurchführt, lässt sich die Leiterbahnstruktur 25 der einen Leiterplatte 29 mit der Leiterbahnstruktur 33 der zweiten Leiterplatte 29 verbinden. Der elektrische Kontakt erfolgt zum Beispiel durch eine Metallisierung der Wandung der Bohrung 39. Mittels einer Bohrung 41, die auf dem als Metallkern ausgebildeten Kühlkörper 37 endet, kann die Leiterbahnstruktur 25, 33 mit dem Metallkern elektrisch kontaktiert werden. Hierdurch lässt sich zum Beispiel ein Massekontakt realisieren. Auch bei der Bohrung 41 erfolgt der elektrische Kontakt vorzugsweise mittels einer Metallisierung. Die Metallisierung der Bohrungen 39, 41 wird zum Beispiel durch stromlose oder galvanische Metallabscheidung erzeugt. Alternativ ist es aber zum Beispiel auch möglich, einen Draht durch die Bohrungen 39, 41 zu führen.

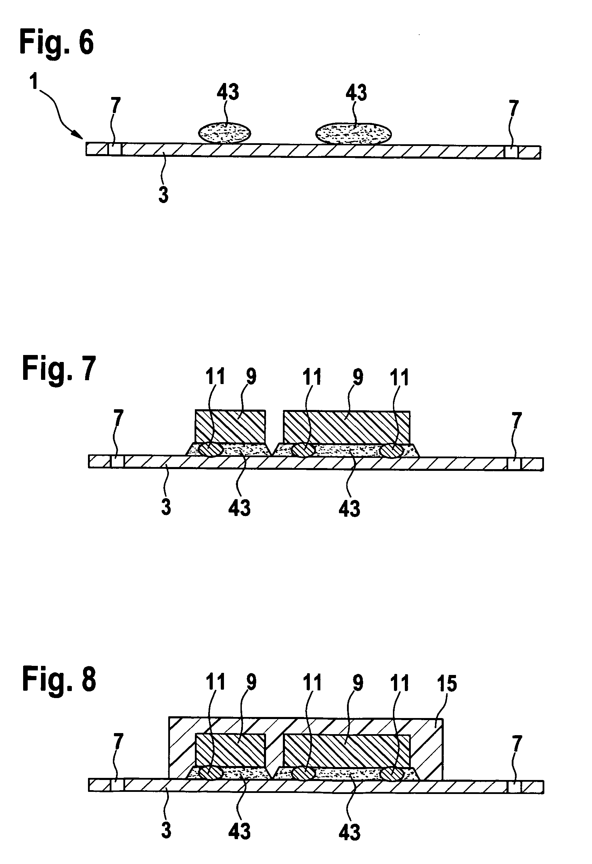

In den Figuren 6 bis 10 ist ein Vergleichsbeispiel zur Herstellung einer elektronischen Baugruppe 27 dargestellt. Das in den Figuren 6 bis 10 dargestellte Verfahren unterscheidet sich darin von dem in den Figuren 1 bis 5 dargestellten Verfahren, dass die leitfähige Folie 1 nur eine leitfähige Schicht 3 und keine isolierende Schicht 5 aufweist. In die leitfähige Folie 1 werden die Justagemarken 7 eingebracht. Zur Befestigung von elektronischen Bauelementen 9 wird auf die leitfähige Folie 1 Klebstoff 43 aufgetragen. Das Auftragen des Klebstoffs 43 kann flächig oder bevorzugt in Form von Klebepunkten, wie dies in Figur 6 dargestellt ist, erfolgen.

Auf die Klebepunkte 43 werden die elektronischen Bauelemente 9, die mit Kontaktpunkten 11 versehen sind, aufgesetzt. Durch die Kontaktpunkte 11 wird der Abstand der elektronischen Bauelemente 9 zur leitfähigen Folie 1 festgelegt. Der Klebstoff 43 füllt den Zwischenraum zwischen dem elektronischen Bauelement 9 und der leitfähigen Folie 1 aus und bildet ein Dielektrikum, so dass die elektronischen Bauelemente 9 nicht mit ihrer aktiven Seite direkt auf der leitfähigen Folie 1 aufliegen. Dies ist in Figur 7 dargestellt.

Um eine Kapselung von empfindlichen elektronischen Bauelementen 9 zu erzielen, ist es möglich, diese mit der Polymermasse 15 zu umschließen. Dies ist in Figur 8 dargestellt. Die Polymermasse 15 ist zum Beispiel eine Epoxid-Niederdruckpressmasse. In die Polymermasse 15 können, wenn erforderlich, zum Beispiel Platzhalter für dickere Dielektrika, die zum Beispiel für Antennen oder Kühlkörper verwendet werden, umspritzt werden. Das Umhüllen mit der Polymermasse 15 erfolgt zum Beispiel mittels eines Spritzpressverfahrens. Die Platzhalter können zum Beispiel als Vertiefung oder Wannen ausgeformt sein. Neben dem Spritzpressverfahren ist jedoch auch jedes andere, dem Fachmann bekannte Verfahren einsetzbar, mit dem sich die elektronischen Bauelemente 9 mit der Polymermasse 15 ummanteln lassen. Zusätzlich hat die Ummantelung mit der Polymermasse 15 den Vorteil, dass ein Höhenausgleich bei Bauelementen 9 mit unterschiedlicher Dicke möglich ist. Dies ist vorteilhaft für den nachfolgenden Laminierprozess. Bauteile können zudem auf abziehbare Folien vorverkapselt werden und nach dem Abziehen der Folie mit Klebstoff 43 auf die Folie 1 montiert werden.

Wie auch bei der in den Figuren 1 bis 5 dargestellten Ausführungsform wird nach dem Aufkleben der elektronischen Bauelemente 9 und gegebenenfalls dem Umkapseln mit der Polymermasse 15 aus der leitfähigen Folie 1 die Leiterbahnstruktur 25 gebildet. Wenn alle elektronischen Bauelemente 9, wie dies in den Figuren 6 bis 10 dargestellt ist, mittels Kontaktpunkten 11 ausgestattet sind und über die Kontaktpunkte 11 mit der leitfähigen Folie 1 verbunden sind, ist es nicht erforderlich, zur elektrischen Kontaktierung Löcher 19 zu bilden, die anschließend metallisiert werden, um einen elektrischen Kontakt herzustellen. Wenn jedoch mit dem Klebstoff 43 weitere elektronische Bauelemente 13 aufgeklebt werden, die keine Kontaktpunkte 11 aufweisen, so werden durch die leitfähige Folie 1 und den Klebstoff 43 Löcher 19 eingebracht, die anschließend metallisiert werden, um das weitere elektronische Bauelement 9, 13 mit der leitfähigen Folie 1 zu kontaktieren. In diesem Fall erfolgt die Strukturierung der leitfähigen Folie 1 zur Leiterbahnstruktur 25 erst nach dem Einbringen der Löcher 19.

Vor dem Strukturieren der leitfähigen Folie 1 zur Leiterbahnstruktur 25 wird auch bei dem in den Figuren 6 bis 10 dargestellten Vergleichsbeispiel zunächst der Leiterplattenträger 17, wie vorstehend bereits beschrieben, auf die leitfähige Folie 1 auflaminiert.

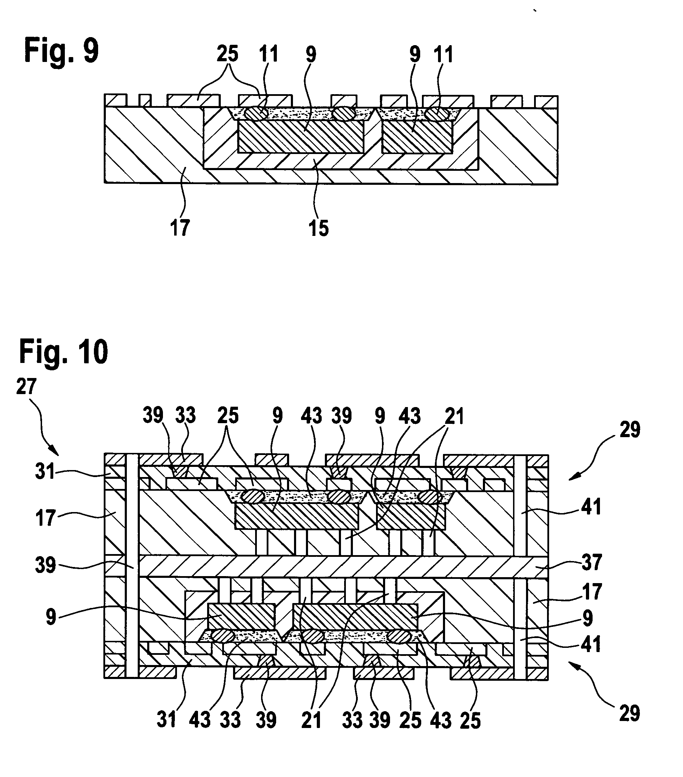

In Figur 10 ist eine elektronische Baugruppe 27 dargestellt, bei der zwei Leiterplatten 29 miteinander verbunden sind. Der Aufbau entspricht dem in Figur 5 dargestellten Aufbau der elektronischen Baugruppe 27. Die in Figur 10 dargestellte elektronische Baugruppe 27 unterscheidet sich von der in Figur 5 dargestellten Ausführungsform dadurch, dass keine durchgehende isolierende Schicht 5 zwischen dem Leiterplattenträger 17 und der Leiterbahnstruktur 25 ausgebildet ist. Als Dielektrikum zwischen der Leiterbahnstruktur 25 und dem elektronischen Bauelement 9 dient der Klebstoff 43, mit dem die elektronischen Bauelemente 9 auf die Leiterbahnstruktur 25 aufgeklebt sind. In Bereichen, in denen sich kein elektronisches Bauelement 9 befindet, ist die Leiterbahnstruktur 25 direkt auf dem Leiterplattenträger 17 aufgebracht.

## Patentansprüche

1. Verfahren zur Herstellung einer elektronischen Baugruppe (27), umfassend eine Leiterplatte mit mindestens einem elektronischen Bauelement (9, 13), welches folgende Schritte umfasst:
(a) Befestigen von mindestens einem elektronischen Bauelement (9) mit Kontaktierungspunkten (11) auf einer leitfähigen Folie (1), wobei die aktive Seite des mindestens einen elektronischen Bauelements in Richtung der leitfähigen Folie (1) weist und die Kontaktierungspunkte (11) an Kontaktierungsstellen auf der aktiven Seite des elektronischen Bauelements (9) angeordnet sind, wobei die Kontaktierungspunkte kleine Erhebungen aus einem leitfähigen Material sind, die an den Kontaktierungsstellen des elektronischen Bauteils angebracht sind und die Höhe der Erhebungen dem Abstand entspricht, den das elektronische Bauteil von der elektrisch leitfähigen Folie einnehmen soll, und wobei zum Befestigen des mindestens einen elektronischen Bauelements (9) Klebstoff (43) auf die leitfähige Folie (1) aufgetragen wird, wobei der Klebstoff (43) als Dielektrikum zwischen der leitfähigen Folie (1) und dem mindestens einen elektronischen Bauelement (9) wirkt und die Kontaktierungspunkte (11) das Bauelement (9) mit der leitfähigen Folie (1) kontaktieren, wobei kurze Anschlüsse realisiert werden und eine planare Ausgangsstruktur für reproduzierbare Hochfrequenz-Übergänge erzeugt wird,
(b) Auflaminieren der leitfähigen Folie (1) mit dem mindestens einen daran befestigten elektronischen Bauelement (9, 13) auf einen Leiterplattenträger (17), wobei das mindestens eine elektronische Bauelement (9, 13) in Richtung des Leiterplattenträgers (17) weist,
(c) Ausbilden, nach dem Aufkleben des mindestens einen elektronischen Bauelements (9) auf die leitfähige Folie (1) und dem Auflaminieren der leitfähigen Folie (1) auf den Leiterplattenträger (17), einer Leiterbahnstruktur (25) durch Strukturieren der leitfähigen Folie (1),
**dadurch gekennzeichnet, dass**
mindestens ein weiteres elektronisches Bauelement (13) ohne Kontaktierungspunkte auf einer isolierenden Schicht (5) oder einer Klebstoffschicht (43) auf der leitfähigen Folie (1) befestigt wird, und
in die leitfähige Folie (1) an den Positionen, an denen das mindestens eine weitere elektronische Bauelement (13) mit der leitfähigen Folie (1) elektrisch kontaktiert werden soll, Löcher (19) eingebracht werden und die Löcher (19) zur Kontaktierung der leitfähigen Folie (1) mit dem mindestens einen weiteren elektronischen Bauelement (13) metallisiert werden.

2. Verfahren nach Anspruch 1, **dadurch gekennzeichnet, dass** die leitfähige Folie (1) eine isolierende Schicht (5) aufweist und das mindestens eine Bauelement (9) auf der isolierenden Schicht (5) befestigt wird, wobei die Kontaktierungspunkte (11) die isolierende Schicht (5) durchbrechen und das Bauelement (9) mit der leitfähigen Folie (1) kontaktieren.

3. Verfahren nach einem der Ansprüche 1 bis 2, **dadurch gekennzeichnet, dass** das mindestens eine elektronische Bauelement (9, 13) nach dem Befestigen auf der leitfähigen Folie (1) von einer Polymermasse (15) umschlossen wird.

4. Verfahren nach einem der Ansprüche 1 bis 3, **dadurch gekennzeichnet, dass** vor dem Befestigen des mindestens einen elektronischen Bauelements (9, 13) auf der leitfähigen Folie (1) in Schritt (a) Justagemarken (7) in die leitfähige Folie (1) eingebracht werden.

5. Verfahren nach einem der Ansprüche 1 bis 4, **dadurch gekennzeichnet, dass** auf die in Schritt (c) strukturierte leitfähige Folie (1) weitere Lagen, die Leiterbahnstrukturen (33) enthalten, aufgebracht werden.

6. Verfahren nach einem der Ansprüche 1 bis 5, **dadurch gekennzeichnet, dass** das mindestens eine elektronische Bauelement (9, 13) vor dem Auflaminieren in Schritt (b) auf der von der leitfähigen Folie (1) wegweisenden Seite mit einem Kühlkörper (37) kontaktiert wird, so dass der Kühlkörper (37) nach dem Auflaminieren auf den Leiterplattenträger (17) ebenfalls in der Leiterplatte (29) integriert ist.

7. Elektronische Baugruppe, umfassend mindestens ein elektronisches Bauelement (9, 13), welches mit einer Leiterbahnstruktur (25, 33) auf einer Leiterplatte (29) verbunden ist, wobei das mindestens eine elektronische Bauelement (9, 13) in einem Leiterplattenträger (17) eingebettet ist und die Leiterbahnstruktur (25, 33) an der Oberfläche der Leiterplatte (29) angeordnet ist, wobei die Kontaktierung des Bauelements (9) mit der Leiterbahnstruktur (25) durch am Bauelement (9) angebrachte Kontaktierungspunkte (11) erfolgt, wobei die Kontaktierungspunkte kleine Erhebungen aus einem leitfähigen Material sind, die an den Kontaktierungsstellen des elektronischen Bauteils angebracht sind und die Höhe der Erhebungen dem Abstand entspricht, den das elektronische Bauteil von der elektrisch leitfähigen Folie einnimmt, wobei kurze Anschlüsse und eine planare Ausgangsstruktur für reproduzierbare Hochfrequenz-Übergänge ausgebildet sind, und wobei zum Befestigen des mindestens einen elektronischen Bauelements (9) Klebstoff (43) auf die leitfähige Folie (1) aufgetragen ist, wobei der Klebstoff (43) als Dielektrikum zwischen der leitfähigen Folie (1) und dem mindestens einen elektronischen Bauelement (9) wirkt und die Kontaktierungspunkte (11) das Bauelement (9) mit der leitfähigen Folie (1) kontaktieren,
**dadurch gekennzeichnet, dass**
mindestens ein weiteres elektronisches Bauelement (13) ohne Kontaktierungspunkte auf einer Isolierenden Schicht (5) oder einer Klebstoffschicht (43) auf der leitfähigen Folie (1) befestigt ist, wobei in die leitfähige Folie (1) an den Positionen, an denen das mindestens eine weitere elektronische Bauelement (13) mit der leitfähigen Folie (1) elektrisch kontaktiert werden soll, Löcher (19) eingebracht sind und die Löcher (19) zur Kontaktierung der leitfähigen Folie (1) mit dem mindestens einen weiteren elektronischen Bauelement (13) metallisiert sind, und
die elektronische Baugruppe in einem Verfahren gemäß einem der Ansprüche 1 bis 6 herstellbar ist.

8. Elektronische Baugruppe nach Anspruch 7, **dadurch gekennzeichnet, dass** die Kontaktierungspunkte (11) Lötbumps oder Studbumps sind.

9. Elektronische Baugruppe nach Anspruch 7 oder 8, **dadurch gekennzeichnet, dass** die Leiterbahnstruktur (25, 33) in mehreren Lagen ausgebildet ist.

## Claims

1. Method for the production of an electronic assembly (27), comprising a circuit board with at least one electronic component (9, 13), which comprises the following steps:
(a) fastening at least one electronic component (9) having contacting points (11) on a conductive film (1), the active side of the at least one electronic component facing in the direction of the conductive film (1) and the contacting points (11) being arranged at contacting locations on the active side of the electronic component (9), the contacting points being small elevations of a conductive material that are attached at the contacting locations of the electronic component and the height of the elevations corresponding to the distance from the electrically conductive film that the electronic component is intended to assume, and adhesive (43) being applied to the conductive film (1) to fasten the at least one electronic component (9), the adhesive (43) acting as a dielectric between the conductive film (1) and the at least one electronic component (9) and the contacting points (11) establishing the contact between the component (9) and the conductive film (1), short connections being realized and a planar starting structure for reproducible high-frequency junctions being created,
(b) laminating the conductive film (1) with the at least one electronic component (9, 13) fastened thereto onto a circuit board carrier (17), the at least one electronic component (9, 13) facing in the direction of the circuit board carrier (17),
(c) after adhesively attaching the at least one electronic component (9) to the conductive film (1) and laminating the conductive film (1) onto the circuit board carrier (17), forming a strip conductor pattern (25) by patterning the conductive film (1),
**characterized in that**
at least one further electronic component (13) without contacting points is fastened on an insulating layer (5) or an adhesive layer (43) on the conductive film (1), and
holes (19) are introduced into the conductive film (1) at the positions at which the electrical contact is intended to be established between the at least one further electronic component (13) and the conductive film (1), and the holes (19) for establishing the contact between the conductive film (1) and the at least one further electronic component (13) are metallized.

2. Method according to Claim 1, **characterized in that** the conductive film (1) has an insulating layer (5) and the at least one component (9) is fastened on the insulating layer (5), the contacting points (11) breaking through the insulating layer (5) and establishing the contact between the component (9) and the conductive film (1).

3. Method according to either of Claims 1 and 2, **characterized in that** the at least one electronic component (9, 13) is enclosed by a polymer compound (15) after being fastened on the conductive film (1).

4. Method according to one of Claims 1 to 3, **characterized in that**, before the fastening of the at least one electronic component (9, 13) on the conductive film (1) in step (a), adjusting marks (7) are introduced into the conductive film (1).

5. Method according to one of Claims 1 to 4, **characterized in that** further layers that contain strip conductor patterns (33) are applied to the conductive film (1) patterned in step (c).

6. Method according to one of Claims 1 to 5, **characterized in that**, before the lamination in step (b), the at least one electronic component (9, 13) is brought into contact with a heat sink (37) on the side facing away from the conductive film (1), so that, after the lamination onto the circuit board carrier (17), the heat sink (37) is likewise integrated in the circuit board (29).

7. Electronic assembly, comprising at least one electronic component (9, 13), which is connected to a strip conductor pattern (25, 33) on a circuit board (29), the at least one electronic component (9, 13) being embedded in a circuit board carrier (17) and the strip conductor pattern (25, 33) being arranged on the surface of the circuit board (29), the contacting of the component (9) with the strip conductor pattern (25) taking place by contacting points (11) attached to the component (9), the contacting points being small elevations of a conductive material that are attached at the contacting locations of the electronic component and the height of the elevations corresponding to the distance from the electrically conductive film that the electronic component assumes, short connections and a planar starting structure for reproducible high-frequency junctions having been formed, and adhesive (43) having been applied to the conductive film (1) to fasten the at least one electronic component (9), the adhesive (43) acting as a dielectric between the conductive film (1) and the at least one electronic component (9) and the contacting points (11) establishing the contact between the component (9) and the conductive film (1),
**characterized in that**
at least one further electronic component (13) without contacting points has been fastened on an insulating layer (5) or an adhesive layer (43) on the conductive film (1), holes (19) having been introduced into the conductive film (1) at the positions at which the electrical contact was intended to be established between the at least one further electronic component (13) and the conductive film (1), and the holes (19) for establishing the contact between the conductive film (1) and the at least one further electronic component (13) having been metallized, and
the electronic assembly can be produced in a method according to one of Claims 1 to 6.

8. Electronic assembly according to Claim 7, **characterized in that** the contacting points (11) are solder bumps or stud bumps.

9. Electronic assembly according to Claim 7 or 8, **characterized in that** the strip conductor pattern (25, 33) is formed in a number of layers.

## Revendications

1. Procédé de production d'un module électronique (27) qui comporte une carte de circuit dotée d'au moins un composant électronique (9, 13), le procédé comportant les étapes suivantes :
(a) fixation d'au moins un composant électronique (9) par des points de mise en contact (11) sur une feuille conductrice (1), le côté actif du ou des composants électroniques étant orienté en direction de la feuille conductrice (1) et les points (11) de mise en contact étant disposés en des emplacements de mise en contact du côté actif du composant électronique (9), les points de mise en contact étant de petits rehaussements en matériau conducteur placés sur les emplacements de mise en contact du composant électronique, la hauteur des rehaussements correspondant à la distance que le composant électronique doit prendre par rapport à la feuille électriquement conductrice,
la fixation du ou des composants électroniques (9) s'effectuant par application d'un adhésif (43) sur la feuille conductrice (1), l'adhésif (43) agissant comme diélectrique entre la feuille conductrice (1) et le ou les composants électroniques (9) et les points (11) de mise en contact assurant le contact entre le composant (9) et la feuille conductrice (1), de courtes bornes de raccordement étant réalisées et une structure plane de sortie étant formée de manière à obtenir des transitions à haute fréquence reproductibles,
(b) stratification de la feuille conductrice (1) portant le ou les composants électroniques (9, 13) qui y sont fixés sur un support (17) de carte de circuit, le ou les composants électroniques (9, 13) étant tournés en direction du support (17) de carte de circuit,
(c) après le collage du ou des composants électroniques (9) sur la feuille conductrice (1) et la stratification de la feuille conductrice (1) sur le support (17) de carte de circuit, formation d'une structure (25) de pistes conductrices par structuration de la feuille conductrice (1),
**caractérisé en ce que**
au moins un autre composant électronique (13) exempt de points de mise en contact est fixé sur une couche isolante (5) ou sur une couche d'adhésif (43) prévue sur la feuille conductrice (1) et
**en ce que** des trous (19) sont ménagés dans la feuille conductrice (1) en les positions auxquelles le ou les composants électroniques (13) doivent être mis en contact électrique avec la feuille conductrice (1), les trous (19) étant métallisés en vue d'assurer le contact entre la feuille conductrice (1) et le ou les autres composants électroniques (13).

2. Procédé selon la revendication 1, **caractérisé en ce que** la feuille conductrice (1) présente une couche isolante (5) et **en ce que** le ou les composants (9) sont fixés sur la couche isolante (5), les points (11) de mise en contact traversant la couche isolante (5) et assurant le contact entre le composant (9) et la feuille conductrice (1).

3. Procédé selon l'une des revendications 1 et 2, **caractérisé en ce que** le ou les composants électroniques (9, 13) sont englobés dans une pâte polymère (15) après avoir été fixés sur la feuille conductrice (1).

4. Procédé selon l'une des revendications 1 à 3, **caractérisé en ce que** des repères de positionnement (7) sont apportés sur la feuille conductrice (1) avant la fixation du ou des composants électroniques (9, 13) sur la feuille conductrice (1) à l'étape (a).

5. Procédé selon l'une des revendications 1 à 4, **caractérisé en ce que** d'autres couches qui contiennent les structures (33) de pistes conductrices sont appliquées sur la feuille conductrice (1) structurée à l'étape (c).

6. Procédé selon l'une des revendications 1 à 5, **caractérisé en ce qu'**avant la stratification de l'étape (b), le ou les composants électroniques (9, 13) sont mis en contact avec un corps de refroidissement (37) sur leur côté non tourné vers la feuille conductrice (1) de telle sorte que le corps de refroidissement (37) soit également intégré dans la carte de circuit (29) après la stratification sur le support (17) de carte de circuit.

7. Module électronique comprenant au moins un composant électronique (9, 13) raccordé à une structure (25, 33) de pistes conductrices d'une carte de circuit (29), le ou les composants électroniques (9, 13) étant incorporés dans un support (17) de carte de circuit et la structure (25, 33) de pistes conductrices étant disposée sur la surface de la carte de circuit (29), la mise en contact du composant (9) avec la structure (25) de pistes conductrices s'effectuant par des points (11) de mise en contact placés sur le composant (9), les points de mise en contact étant de petits rehaussements en matériau conducteur placés en les emplacements de mise en contact du composant électronique et la hauteur des rehaussements correspondant à la distance que le composant électronique prend par rapport à la feuille conductrice, de courtes bornes de raccordement et une structure plane de sortie étant formées pour permettre des transitions à haute fréquence reproductibles, un adhésif (43) étant appliqué sur la feuille conductrice (1) pour fixer le ou les composants électroniques (9), l'adhésif (43) agissant comme diélectrique entre la feuille conductrice (1) et le ou les composants électroniques (9) et les points (11) de mise en contact assurant le contact entre le composant (9) et la feuille conductrice (1),
**caractérisé en ce que**
au moins un autre composant électronique (13) exempt de points de mise en contact est fixé sur une couche isolante (5) ou sur une couche d'adhésif (43) prévue sur la feuille conductrice (1) et
**en ce que** des trous (19) sont ménagés dans la feuille conductrice (1) en les positions auxquelles le ou les composants électroniques (13) doivent être mis en contact électrique avec la feuille conductrice (1), les trous (19) étant métallisés en vue d'assurer le contact entre la feuille conductrice (1) et le ou les autres composants électroniques (13) et
le module électronique peut être produit par un procédé selon l'une des revendications 1 à 6.

8. Module électronique selon la revendication 7, **caractérisé en ce que** les points (11) de mise en contact sont des bosses brasées ou des bosses rivetées.

9. Module électronique selon les revendications 7 ou 8, **caractérisé en ce que** la structure (25, 33) de pistes conductrices est configurée en plusieurs couches.
